# EUROPÄISCHE PATENTSCHRIFT

(11) **EP 0 396 695 B1**
(45) Veröffentlichungstag und Bekanntmachung des Hinweises auf die Patenterteilung: **02.03.1994**
(21) Anmeldenummer: 89912216.2
(22) Anmeldetag: 13.11.1989
(51) Int. Cl.: G01R 19/14

(54) **UNIVERSALAUSGANGSSCHALTUNG**
UNIVERSAL OUTPUT CIRCUIT
CIRCUIT DE SORTIE UNIVERSEL

(30) Priorität: 18.11.1988 CH 4289/88
(43) Veröffentlichungstag der Anmeldung: 14.11.1990
(73) Patentinhaber: BAUMER ELECTRIC AG, 8500 Frauenfeld (CH)
(72) Erfinder: VIETZE, Helmut, CH-8500 Frauenfeld (CH); WEISSHAUPT, Bruno, CH-8500 Frauenfeld (CH); SCHOY, Albrecht, CH-2000 Neuchâtel (CH); MILLER, Robin, James, Hants (GB)
(74) Vertreter: Frei, Alexandra Sarah
(86) Internationale Anmeldenummer: CH8900197
(87) Internationale Veröffentlichungsnummer: WO9005918

(56) Entgegenhaltungen:
- BE-A- 898 044
- US-A- 3 819 951
- US-A- 4 157 507
- Elektor, Band 7, Nr. 7/8, Juli/August 1981, (Canterbury, Kent, GB), "&-polarity converter"

## Beschreibung

Die Erfindung bezieht sich auf ein Verfahren und eine Ausgangsschaltung gemäss den Oberbegriffen von Patentanspruch 1 und 7, zum selbsttätigen Erkennen, an welche Polarität einer Spannungsquelle ein elektrischer Anschluss eines Verbrauchers angeschlossen ist, und zur selbsttätigen Zuordnung der entsprechenden Stromquelle bzw. Stromsenke an einen Verbraucher.

Ausgangsschaltungen, die Leistung schalten, werden in der Regel mit Transistoren realisiert. Im Zusammenhang mit der Erfindung sind hier Ausgangsschaltungen gemeint, die im Sinne des Wortes schalten, also einen Schaltstrom führen. Je nach Verwendung der Transistoren kann es sich um solche vom NPN- oder PNP-Typ handeln, welche entgegengesetzte Stromrichtungen haben, also gegen ein positives bzw. gegen ein negatives Potential schalten. Dementsprechend sind die Schaltungen, die den Schaltstrom führen, ausgelegt und dementsprechend müssen die Schaltungen, die mit dem Schaltstrom geschaltet werden, auch ausgelegt sein.

Um hier mehr Freiheit zu haben, werden, mit dem entsprechend erhöhten Schaltungsaufwand, Ausgangsschaltungen verwendet, die einen Schaltstrom gegen beide Potentiale (-) minus und (+) plus führen können, ein Beispiel ist die Gegentaktschaltung (push/pull-Schaltung). Von dieser Grundschaltung ausgehend, gibt es anwendungsbezogene Abwandlungen mit entsprechenden Vor- und Nachteilen.

Eingehend auf eine typische Anwenderproblematik, sind hier Positionssensoren genannt. Dabei kann es sich um Positionssensoren handeln, die induktiv, mit Ultraschall, optisch oder kapazitiv arbeiten. Hier sieht man schon, welche Vielfalt von Schaltungen möglich sind, die alle eine Ausgangsschaltung zur "Schaltung" irgendeines Anwenders aufweisen. Solche Positionssensoren weisen entweder einen gegen (+) schaltenden Ausgang oder einen gegen (-) schaltenden Ausgang, gegebenfalls auch die Möglichkeit für beides auf, wobei die letztere Möglichkeit, bspw. eine Gegentaktausgangsschaltung, nicht gleichzeitig anwendbar ist. Die Schaltfunktion kann so ausgelegt sein, dass durch die physikalische Sensorfunktion die Auslösung des Schalters bewirkt (NO, Schliesser) oder zurückgenommen (NC, Öffner) wird. Der Anwender muss sich beim Anschliessen entweder für einen (+ )-Schliesser und damit (-)-Oeffner oder für einen (-)-Schliesser und damit (+)-Oeffner entscheiden. Auch weitergebildete Varianten in Richtung einer universellen Ausgangsschaltung müssen stets umverdrahtet werden, um die gewünschte Schaltpolung zu erhalten.

Aus der US-A-3,819,951 ist eine Schaltung bekannt, die es erlaubt, eine Last, die eine vorgegebene Polarität aufweist, mit einer Stromquelle zu verbinden, die verschiedene Polaritäten aufweisen kann. Diese Schaltung ist bei Fernsprecheinrichtungen besonders nützlich und weist vier Transistoren auf, die so geschaltet sind, dass sie die geforderte Verbindung bereitstellen können.

Der Nachteil dieser genannten Schaltung besteht darin, dass sie nur für Lasten mit einer festen unveränderbaren Polarität ausgebildet ist. Lasten anderer oder wechselnder Polarität können daran nicht angeschlossen werden. Zudem weist diese Schaltung vier Transistoren und damit entsprechend höhere Verluste und eine erhöhte Störanfälligkeit auf.

Es ist daher die Aufgabe der Erfindung ein Verfahren zur selbsttätigen Erkennung der veränderlichen Polarität des elektrischen Anschlusses eines Verbrauchers und zur selbsttätigen Zuordnung der entsprechenden Stromquelle oder umgekehrt der entsprechenden Stromsenke an den Verbraucher anzugeben, sowie eine Ausgangsschaltung im Sinne einer Schnittstelle zwischen zwei Schaltungen, zur Realisierung des Verfahrens anzugeben, insbesondere eine Ausgangschaltung für schaltende Netzwerke zu schaffen, die diese Nachteile nicht mehr aufweist, sondern ohne Verdrahtungsänderung beziehungsweise Leitungsvertauschen die gewünschte Schaltpolung selbsttätig einstellt. Diese Ausgangsschaltung soll zudem einen möglichst geringen Schaltungsaufwand aufweisen, zuverlässig sein und damit deren breitgefächerte Anwendung nicht durch bauliche und wirtschaftliche Erwägungen eingeschränkt sein.

Diese Aufgabe wird durch die im kennzeichnenden Teil des Verfahrensanspruchs 1 und Schaltungsanspruchs 7 angegebene Erfindung gelöst.

Anhand der unten aufgeführten Figuren wird nun eine Ausführungsform der erfindungsgemässen Ausgangsschaltung eingehend diskutiert.
Figur 1 zeigt a bis c die drei eingangs erwähnten Varianten von Schaltungsausgängen gemäss Stand der Technik, a gegen ein positives Potential, b gegen ein negatives Potential und c in Form einer Gegentaktschaltung gegen das eine oder andere Potential.
Figur 2 zeigt die Prinzipschaltung einer erfindungsgemässen Ausführungsform mit Stromabtastung und
Figur 3 zeigt die Prinzipschaltung einer erfindungsgemässen Ausführungsform mit Spannungsabtastung.

Die erfindungsgemässe Ausgangsschaltung enthält als wesentlichen Teil eine wenig aufwendige Mess-Schaltung. Die Erfindung geht von der Idee aus, in der Ausgangsschaltung einen Indikator-Strom zu generieren, der bspw. über ein Sperrelement, durch die äussere Beschaltung, also die Beschaltung des Anwenders, fliesst oder, bei umgekehrter Polarität, des Ventiles wegen, eben nicht fliesst. Die Mess-Schaltung kann dadurch erkennen, ob die an den Klemmen liegende Last (Anwenderschaltung) gegen ein negatives oder positives Potential geschaltet ist. An Stelle einer Stromabtastung eines Indikatorstromes, kann auch eine symmetrisierte Spannung an die Anwenderschaltung angeschlossen werden, welche, je nach Polarität, diese Symmetrie nach der einen oder anderen Polarität zieht und die Schaltung zu einer die entstandene Unsymmetrie wieder aufhebenden Gegenreaktion bringt, welche anzeigt, ob die Anwenderschaltung gegen ein negatives oder positives Potential geschaltet ist. Dem entsprechend werden in beiden Fällen, der Strom- oder Spannungsabtastung, von der Ausgangsschaltung eine NPN- oder PNP-Treiberstufe, welche beide in der Ausgangsschaltung schon vorgesehen sind, an die Last geschaltet. Eine Umpolung, Umverdrahtung oder ähnliche Massnahmen sind damit überflüssig geworden, was sich natürlich auch auf die Sicherheit gegen Fehlanschlüsse bei der Montage auswirkt. So weist bspw. ein Näherungsschalter mit der Ausgangsschaltung gemäss Erfindung zwei "neutrale" Anschlüsse auf, die mit der Anwenderschaltung verbunden werden. Alles weitere wird durch die Ausgangsschaltung selber bewirkt. Ein weiterer markanter Effekt ist natürlich die dadurch ermöglichte stark verringerte Lagerhaltung; es müssen nicht mehr Typen von verschiedenen Ausgangsstufen (PNP- oder NPN-Schliesser bzw. -Öffner) bereitgehalten werden.

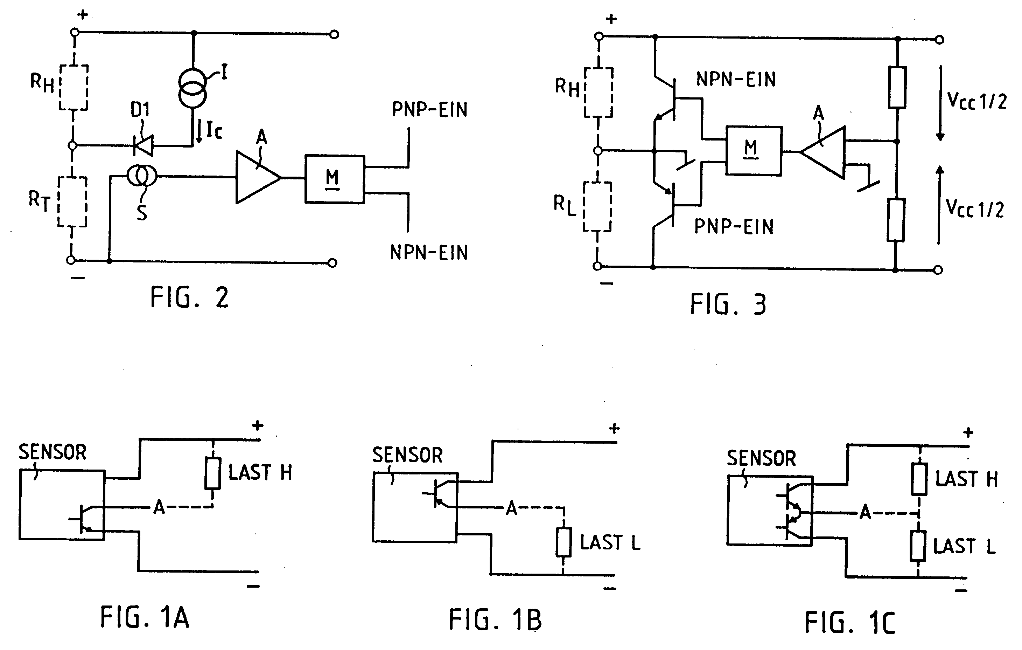

Es ist klar, dass die zum Stand der Technik in den **Figuren 1a, 1b, 1c** dargestellten Transistoren-Ausgänge diese Vorteile nicht aufweisen, da sie entweder im PNP- oder NPN-Modus arbeiten und beim entsprechenden Signal an der Basis in der einzig möglichen Stromrichtung durchschalten. Bei der unter **c** abgebildeten Gegentaktschaltung ist es auch nicht anders, sie arbeitet entweder im NPN- oder im PNP-Modus, je nachdem, zwischen welchen Klemmen die Last geschaltet ist.

Die Figuren 2 und 3 zeigen hier die völlig selbsttätige Umschaltung der Ausgangsstufe auf die eine oder andere Treiberart.

### Grundprinzip der erfindungsgemässen Ausgangsschaltung:

Das Grundprinzip ist das folgende. Eine Mess-Schaltung in der Ausgangsschaltung des bspw. Sensors misst bei der an ihre Klemmen angelegte Anwenderschaltung, gegen welche Spannungspolarität sie angeschlossen ist. Die Detektion des einen oder anderen der beiden Zustände wird in einem speichernden Element M diesen Zustand fixieren und den richtigen Treiber an die Ausgangsklemmen schalten. Dieser Zustand bleibt solange erhalten, wie sich an den Ausgangsklemmen bezüglich ihrer Polung nichts ändert. Werden bspw. durch den Austausch eines defekten Relais die Anschlussklemmen vertauscht, es besteht ja keine Vorschrift mehr, wie angeschlossen werden muss, so stellt die Mess-Schaltung den Speicherzustand gleich wieder richtig, sodass auch der jeweils richtige Treiber der Anwenderschaltung zugeordnet wird.

Grundsätzlich kann die Mess-Schaltung auf zwei Indikatoren ausgelegt werden, nämlich die Stromabtastung oder die Spannungsabtastung. Für beide Möglichkeiten wird nachfolgend ein Ausführungsbeispiel angegeben.

### Stromabtastung der Ausgangsklemmen (Fig. 2):

Ein Strom I_{c} wird von einer Stromquelle I durch eine Diode D1 geschickt. Ist die Last nun gegen ein niedrigeres Potential (-) geschaltet, wie es bei R_{T} der Fall ist, so kann der Strom I_{c} durch die Diode fliessen. Mittels eines Stromspiegels S wird dieser Stromfluss detektiert und verstärkt. Dem Stromspiegel nachgeschaltet ist ein (transimpedanz) Verstärker A, welcher an seinem Ausgang eine dem detetkierten Strom proportionale Spannung abgibt. Diese Spannung wird in einer nachfolgenden Schaltung für die Zuweisung des einen oder des anderen Treibers ausgewertet.

Ist die Last hingegen gegen ein höheres Potential (+) geschaltet, wie es bei R_{H} der Fall ist, so kann kein Strom durch die Diode fliessen. Dies merkt der Stromspiegel M natürlich auch und meldet dem nachgeschalteten Verstärker A "kein Strom", was sich am Verstärkerausgang durch ein entsprechendes Spannungssignal bemerkbar macht.

Somit können am Ausgang des Verstärkers A die beiden Zustände jeweils abgelesen werden, gegen welches Potential, ob Hoch oder Tief, die angehängte Last geschaltet ist. Diese beiden Mess-Signale können nun benützt werden, um durch eine speichernde Schaltung den jeweiligen Schaltungszustand festzuhalten, gemäss welchem die zuständige Treiberstufe zugeschaltet wird.

### Spannungsabtastung der Ausgangsklemmen (Fig.3):

Eine analoge Ausführungsform benützt statt eine "Strominformation" eine "Spannungsinformation", bei welcher die durch den Indikatorstrom in der Last hervorgerufene Spannung abgetastet wird. Diese Sensorstelle kann bspw. durch Schaltung, die die Speisespannung V_{cc} symmetrisch aufteilt und die beiden V_{cc½} gegen ein Nullpotential vergleicht. Je nach Anschluss der Aussenlast tritt eine Assymmetrie nach der einen oder anderen Polarität auf, die zu einem kompensierenden Ausgleich der Schaltung führt, bspw. das Durchsteuern einer der beiden Transistoren einer Gegentaktsschaltung, welcher Strom (Signal) zum Stellen des Speicherelements (bspw. eines Flip-Flop) verwendet werden kann.

### Betrieb eines Näherungssensors mit erfindungsgemässer Ausgangsschaltung:

Die automatische Lasterkennung erfolgt vorzugsweise in der Aufstartphase während der Zeit der Einschaltimpulsunterdrückung des Näherungssensors. Die Einschaltimpulsunterdrückung dauert 20-40 ms und dieses Zeitfenster ist gross genug, die Messung und das Stellen des Speicherbausteins durchzuführen. Wird die Unterdrückung aufgehoben, so ist die Schnittstelle und damit der mit ihr verbundene Sensor zu der als Last ausgelegte Schaltung des Anwenders richtig gepolt. Während des Aufstartens wird also die Zeitspanne ganz zu Beginn verwendet, um mit Hilfe des Indikatorstromes die Last zu bestimmen. Das Resultat, der eine oder andere Zustand, wird in einer Speicherschaltung, bspw. ein Flip-Flop gespeichert und die Stromrichtung durch die Last freigegeben. Dies ist entweder in Richtung zu einer Quelle (+), durch einen NPN-Treibertransistor, oder in Richtung zu einer Senke (-), durch einen PNP-Treibertransistor, je nachdem der Ausgang des Flip-Flops gesetzt ist. Auf diese Weise ist ausserdem sichergestellt, dass nicht beide Treiber gleichzeitig eingeschaltet sind.

Die Mess-Schaltung in der Ausgangsschaltung des bspw. Sensors misst also bei der an ihre Klemmen angelegte Anwenderschaltung, gegen welche Spannungspolarität sie angeschlossen ist. Die Detektion des einen oder anderen der beiden Zustände wird dazu benützt, in einem speichernden Element diesen Zustand fixieren und den richtigen Treiber an die Ausgangsklemmen schalten. Dieser Zustand bleibt solange erhalten, wie sich an den Ausgangsklemmen bezüglich ihrer Polung nichts ändert. Werden bspw. durch den Austausch eines defekten Relais die Anschlussklemmen vertauscht, so stellt die Mess-Schaltung den Speicherzustand gleich wieder richtig, sodass auch der jeweils richtige Treiber der Anwenderschaltung zugeordnet wird. Werden andererseits zum Beispiel durch den Austausch einer Steuerungskarte oder einer Steuerung nun neu (+) anstatt (-) schaltende Sensoren benötigt, müssen die Geräte nicht mehr, wie das bis anhin üblich war, ausgewechselt werden. Sie werden nun durch die erfindungsgemässe Massnahme beim Einschalten der Spannung initialisiert (neu konditioniert), wodurch der aktuelle, also den neuen Gegebenheiten entsprechende Zustand gesetzt wird.

## Patentansprüche

1. Verfahren zum selbsttätigen Erkennen, an welche Polarität einer Spannungsquelle in einer Ausgangsschaltung ein erster elektrischer Anschluss eines Verbrauchers (R_{H}, R_{T}) an eine erste Ausgangsklemme der Ausgangsschaltung angeschlossen ist und zur selbsttätigen Zuordnung von einer Stromquelle beziehungsweise einer Stromsenke an einen zweiten elektrischen Anschluss des Verbrauchers, wobei dieser zweite elektrische Anschluss des Verbrauchers an eine zweite Ausgangsklemme der Ausgangsschaltung angeschlossen ist, dadurch gekennzeichnet, dass in einer Messschaltung in der Ausgangsschaltung eine Messgrösse in Form eines elektrischen Stromes beziehungsweise einer elektrischen Spannung erzeugt und an die zweite Ausgangsklemme der Ausgangsschaltung angelegt wird, wodurch ein Speicherelement (M) abhängig von der Polarität des ersten elektrischen Anschlusses des Verbrauchers in einen von zwei definierten Zuständen gebracht wird und je nach Speicherzustand eine Stromquelle beziehungsweise eine Stromsenke der zweiten Ausgangsklemme der Ausgangsschaltung zugeordnet wird.

2. Verfahren nach Anspruch 1, dadurch gekennzeichnet, dass dem einen Speicherzustand die Stromquelle, ausgebildet mit einem PNP-Treibertransistor, und dem anderen Speicherzustand die Stromsenke, ausgebildet mit einem NPN--Treibertransistor zugeordnet werden.

3. Verfahren nach Anspruch 1, dadurch gekennzeichnet, dass zur Erzeugung der Messgrösse ein Stromspiegel (S) verwendet wird, der das Speicherelement (M), ausgebildet als ein Flip-Flop, umstellt.

4. Verfahren nach Anspruch 1, dadurch gekennzeichnet, dass zur Erzeugung der Messgrösse eine Schaltung zur spannungssymmetrischen Aufteilung einer Speisespannung verwendet wird, die das Speicherelement (M), ausgebildet als ein Flip-Flop, umstellt.

5. Verfahren nach einem der Ansprüche 3 oder 4, dadurch gekennzeichnet, dass an den Flip-Flop eine NPN- und eine PNP-Stromquelle angeschlossen sind, die je einem Flip-Flop-Ausgangszustand zugeordnet werden.

6. Verfahren nach Anspruch 5, dadurch gekennzeichnet, dass der vom Flip-Flop eingestellte Zustand der Zuordnung der Speisung an den Ausgangsklemmen der Ausgangsschaltung solange erhalten bleibt, wie sich an den Ausgangsklemmen bezüglich der Polung nichts ändert.

7. Elektronische Ausgangsschaltung, mit einer ersten Ausgangsklemme für einen ersten elektrischen Anschluss eines Verbrauchers (R_{H}, R_{T}) und zur selbsttätigen Zuordnung von einer Stromquelle (PNP-EIN) beziehungsweise einer Stromsenke (NPN-EIN) an eine zweite Ausgangsklemme für einen zweiten elektrischen Anschluss des Verbrauchers, gekennzeichnet durch eine Messschaltung, in der eine Messgrösse in Form eines elektrischen Stromes beziehungsweise einer elektrischen Spannung erzeugt und an die zweite Ausgangsklemme der Ausgangsschaltung angelegt ist, durch ein Speicherelement (M) mit zwei definierten Zuständen welche abhängig von der Polarität des ersten elektrischen Anschlusses des Verbrauchers sind und gekennzeichnet durch eine Stromquelle beziehungsweise eine Stromsenke, die je nach dem Zustand des Speicherelementes, der zweiten Ausgangsklemme der Ausgangsschaltung zugeordnet ist.

8. Elektronische Schaltung nach Anspruch 7, dadurch gekennzeichnet, dass die Messschaltung eine, zwischen die erste und die zweite Ausgangsklemme geschaltete, Stromquelle mit in Serie geschalteter Diode und eine weitere Schaltung, die zusammen einen Stromspiegel bilden, enthält, mit einem Ausgang, der mit dem Eingang eines Speicherelementes verbunden ist.

9. Elektronische Schaltung nach Anspruch 7, dadurch gekennzeichnet, dass die Messschaltung eine, auf ein Nullpotential bezogene, Schaltung zur symmetrischen Aufteilung einer Speisespannung ist, die einen Ausgang aufweist, der mit einem Speicherelement verbunden ist.

10. Elektronische Schaltung nach Anspruch 8 oder 9, dadurch gekennzeichnet, dass das Speicherelement ein Flip-Flop ist.

11. Elektronische Schaltung nach einem der Ansprüche 7 bis 10, dadurch gekennzeichnet, dass dem Speicherelement Stromquellen bzw. Stromsenken zugeordnet sind.

12. Elektronische Schaltung nach Anspruch 11, dadurch gekennzeichnet, dass im Speicherelement zwei Speicherzustände vorgesehen sind, dass die Stromquellen bzw. Stromsenken mit NPN- und PNP-geschalteten Treibertransistoren ausgebildet sind und dass jedem der beiden Speicherzustände eine Stromquelle bzw. Stromsenke zugeordnet ist.

13. Positions- oder Näherungssensor, dadurch gekennzeichnet, dass er eine Ausgangsschaltung gemäss Anspruch 7 aufweist.

## Claims

1. Method for the automatic detection of the polarity of a voltage source in an output circuit at which a first electrical connection of a load (R_{H}, R_{T}) is connected to a first output terminal of the output circuit and for the automatic association of a current source or current drain with a second electrical connection of the load, said second electrical connection of the load being connected to a second output terminal of the output circuit, characterized in that in a measurement circuit in the output circuit a measured quantity in the form of an electrical current or voltage is generated and applied to the second output terminal of the output circuit, so that a storage element (M) is brought into one of two defined states, as a function of the polarity of the first electrical connection of the load, and as a function of the storage state a current source or current drain is associated with the second output terminal of the output circuit.

2. Method according to claim 1, characterized in that with the first storage state is associated the current source constructed with a PNP driver transistor and with the other storage state the current drain constructed with a NPN driver transistor.

3. Method according to claim 1, characterized in that for producing the measured quantity use is made of a current mirror (S), which changes over the storage element (M), constructed as a flip-flop.

4. Method according to claim 1, characterized in that for producing the measured quantity use is made of a circuit for the voltage-symmetrical subdivision of a feed voltage, which changes over the storage element (M), constructed as a flip-flop.

5. Method according to one of the claims 3 or 4, characterized in that to the flip-flop are connected a NPN and a PNP current source, which are in each case associated with a flip-flop starting state.

6. Method according to claim 5, characterized in that the flip-flop-set state of the association of the feed to the output terminals of the output circuit is maintained for as long as there is no polarity change to the output terminals.

7. Electronic output circuit with a first output terminal for a first electrical connection of a load (R_{H}, R_{T}) and for the automatic association of a current source (PNP on) respectively a current drain (NPN on) with a second output terminal for a second electrical connection of the load, characterized by a measurement circuit, in which is produced a measured quantity in the form of an electric current or voltage and is applied to the second output terminal of the output circuit, by a storage element (M) with two clearly defined states dependent on the polarity of the first electrical connection of the load and by a current source or drain which, as a function of the state of the storage element, is associated with the second output terminal of the output circuit.

8. Electronic circuit according to claim 7, characterized in that the measurement circuit contains a current source with a series-connected diode connected between the first and second output terminals and a further circuit, which together form a current mirror, with an output, which is connected to the input of a storage element.

9. Electronic circuit according to claim 7, characterized in that the measurement circuit is a zero potential-related circuit for the symmetrical subdivision of a feed voltage, which has an output connected to a storage element.

10. Electronic circuit according to claim 8 or 9, characterized in that the storage element is a flip-flop.

11. Electronic circuit according to one of the claims 7 to 10, characterized in that current sources or drains are associated with the storage element.

12. Electronic circuit according to claim 11, characterized in that there are two storage states in the storage element, that the current sources, respectively drains, are constructed with NPN and PNP-switched driver transistors and that with each of the two storage states is associated a current source respectively drain.

13. Position or proximity sensor, characterized in that it has an output circuit according to claim 7.

## Revendications

1. Procédé permettant de détecter de manière automatique la polarité d'une source de tension d'un circuit de sortie auquel est raccordée une première connexion électrique d'un consommateur (R_{H}, R_{T}) au niveau d'une première borne de sortie du circuit de sortie, d'une part, et d'attribuer de manière automatique une source de courant ou une absence de courant à une deuxième connexion électrique du consommateur raccordée à une deuxième borne de sortie du circuit de sortie, d'autre part, caractérisé en ce qu'une grandeur de mesure sous la forme d'un courant électrique ou d'une tension électrique est générée dans un circuit de mesure faisant partie intégrante du circuit de sortie et appliquée à la deuxième borne du circuit de sortie produisant la commutation d'un élément de mémoire (M) en l'un de deux états préalablement définis en fonction de la polarité de la première connexion électrique du consommateur et en attribuant, en fonction de l'état de l'élément de mémoire, soit une source de courant, soit une absence de courant à la deuxième borne de sortie du circuit de sortie.

2. Procédé selon la revendication 1, caractérisé en ce que la source d'énergie électrique (sous la forme d'un transistor d'attaque PNP) est attribuée à l'un des deux états de l'élément mémoire et que l'absence de courant (sous la forme d'un transistor d'attaque NPN) et attribuée à l'autre état de l'élément mémoire.

3. Procédé selon la revendication 1, caractérisé en ce que la grandeur de mesure est générée par un détecteur de courant (S), provoquant la commutation de l'élément de mémoire (M) réalisé sous la forme d'une bascule électronique.

4. Procédé selon la revendication 1, caractérisé en ce que la génération de la grandeur de mesure est réalisée par un circuit produisant la répartition symétrique de la tension d'alimentation, provoquant la commutation de l'élément de mémoire (M) réalisé sous la forme d'une bascule électronique.

5. Procédé selon la revendication 3 ou 4, caractérisé en ce qu'une source NPN et une source PNP sont raccordées à la bascule électronique dont chacune est attribuée à un état de sortie de la bascule électronique.

6. Procédé selon la revendication 5, caractérisé en ce que l'état commandé par la bascule électronique relatif à l'attribution de l'alimentation aux bornes de sortie du circuit de sortie est maintenu pendant toute la durée pendant laquelle la polarité des bornes de sortie reste inchangée.

7. Circuit de sortie électronique comprenant une première borne de sortie pour une première connexion électrique d'un consommateur (R_{H}, R_{T}) permettant d'attribuer de manière automatique une source du courant (PNP MARCHE) ou une absence de courant (NPN MARCHE) à une deuxième borne de sortie pour une deuxième connexion électrique du consommateur, caractérisé par un circuit de mesure dans lequel une grandeur de mesure sous la forme d'un courant électrique ou d'une tension électrique est générée et appliquée à la deuxième borne de sortie du circuit de sortie, par un élément de mémoire (M) à deux états définis indépendants de la polarité de la première connexion électrique du consommateur, et par une source de courant ou une absence de courant attribuée à la deuxième borne de sortie du circuit de sortie en fonction de l'élément de mémoire.

8. Circuit électronique selon la revendication 7, caractérisé en ce que le circuit de mesure comprend une source de courant avec une diode montée en série entre la première et la deuxième bornes de sortie et un autre circuit avec lequel il forme un détecteur de courant, avec une sortie reliée à l'entrée d'un élément de mémoire.

9. Circuit électronique selon la revendication 7, caractérisé en ce que le circuit de mesure présente un circuit de répartition symétrique d'une tension d'alimentation par rapport à un potentiel zéro présentant une sortie reliée à un élément de mémoire.

10. Circuit électronique selon la revendication 8 ou 9, caractérisé en ce que l'élément de mémoire est constitué par une bascule électronique.

11. Circuit électronique selon l'une quelconque des revendications 7 à 10, caractérisé en ce que des sources de courant ou des absences de courant sont attribuées à l'élément de mémoire.

12. Circuit électronique selon la revendication 11, caractérisé en ce que l'élément de mémoire peut avoir deux états, en ce que les sources de courant ou les absences de courant sont réalisées avec des transistors d'attaque NPN ou PNP respectivement et en qu'une source de courant ou une absence de courant est attribuée à chacun des deux états de l'élément de mémoire.

13. Capteur de position ou de proximité, caractérisé en ce qu'il présente un circuit de sortie selon la revendication 7.
